# EUROPÄISCHE PATENTSCHRIFT

(11) **EP 3 938 238 B1**
(45) Veröffentlichungstag und Bekanntmachung des Hinweises auf die Patenterteilung: **28.12.2022**
(21) Anmeldenummer: 20710903.4
(22) Anmeldetag: 11.03.2020
(51) Int. Cl.: B60N 2/02, G05G 9/047, G05G 13/00, H03K 17/975

(54) **SITZVERSTELLSCHALTER**
SEAT ADJUSTMENT SWITCH
COMMUTATEUR DE RÉGLAGE DE SIÈGE

(30) Priorität: 13.03.2019 DE 102019001781
(43) Veröffentlichungstag der Anmeldung: 19.01.2022
(73) Patentinhaber: KOSTAL Automobil Elektrik GmbH & Co. KG, 58513 Lüdenscheid (DE)
(72) Erfinder: FEHLING, André, 59846 Sundern (DE); HILLE, Hubert, 58708 Menden (DE); BRENSEL, Kai, 58454 Witten (DE)
(74) Vertreter: Kerkmann, Detlef
(86) Internationale Anmeldenummer: PCT/EP2020/056462
(87) Internationale Veröffentlichungsnummer: WO 2020/182861

(56) Entgegenhaltungen:
- DE-A1-102015 014 878
- DE-C1- 19 844 336

## Beschreibung

Die Erfindung betrifft einen Sitzverstellschalter mit mehreren über Sensorzapfen betätigbaren Mehrwegekraftsensoren, die an einer gemeinsamen Trägerplatte angeordnet sind, wobei mit den Sensorzapfen mindestens eine Knopfkappe als Betätigungselement verbunden ist.

Sitzverstellschalter besitzen in der Regel mehrere Schaltelemente, über die verschiedene Funktionen steuerbar sind. Dabei ist das mindestens eine Betätigungselement dieser Schaltelemente oftmals in Form einer stilisierten Sitzkontur ausgebildet. Die Sitzkontur kann entweder in diskreten Blöcken oder monolithisch ausgelegt sein. Über die stilisierte Sitzkontur können zumindest einzelne der Funktionen Kopfstütze hoch/runter und vor/zurück, Sitzlehne vor/zurück sowie Sitzkissen vorne hoch/runter, hinten hoch/runter sowie vor/zurück gesteuert werden.

Im Gegensatz zu früher üblichen Kontaktschaltern werden bei modernen Sitzverstellschaltern bevorzugt Kraftsensoren eingesetzt, die eine oder mehrere Schaltschwellen besitzen. Die Kraftsensoren sind dabei zumeist mechanisch sehr steif ausgelegt.

Ein gattungsgemäßer Sitzverstellschalter mit einer Kraftsensorik ist aus der deutschen Offenlegungsschrift DE 10 2015 014 878 A1 bekannt. Dieses Dokument beschreibt speziell eine Bedienvorrichtung zum Verstellen eines Kraftfahrzeugsitzes. An einem Grundkörper der Bedienvorrichtung ist eine um wenigstens eine Drehachse rotatorisch und entlang wenigstens einer Richtung translatorisch bewegbar gelagerte Schalterkappe angeordnet. Mindestens eine Erfassungsvorrichtung erfasst eine Verlagerung der Schalterkappe durch Bestimmung der auf die Schalterkappe einwirkenden Betätigungskraft nach Betrag und Richtung. In Abhängigkeit von dieser Betätigungskraft ist ein Fahrzeugsitz verstellbar.

Eine einfache und vorteilhafte Ausführungsform einer Erfassungsvorrichtung in Form eines kapazitiven Mehrwegekraftsensors ist aus der deutschen Offenlegungsschrift DE 10 2014 014 021 A1 bekannt.

Der in der DE 10 2014 014 021 A1 beschriebene Mehrwegekraftsensor weist einen zapfenartigen Betätigungshebel auf, der starr mit dem Oberteil eines Gehäuses verbunden ist. Im inneren des Gehäuses ist der Betätigungshebel mit einer metallenen oder metallisierten Platte verbunden. Bei einer Verschwenkung des Betätigungshebels verschwenkt zugleich die Platte gegen metallene oder metallisierte Flächen auf einer Leiterplatte, so dass sich die Kapazitätswerte von den durch die Anordnung von Platte und Flächen gebildeten Kondensatoren mit der Verschwenkbewegung des Betätigungshebels verändern. Da zum Verschwenken des Betätigungshebels zugleich das Oberteil des Gehäuses elastisch verformt werden muss, ist der Mehrwegekraftsensor recht steif, was für eine Anwendung bei einem Sitzverstellschalter durchaus erwünscht ist. Um eine besonders steife Ausführung zu erreichen, kann sowohl der Betätigungshebel als auch das Gehäuseoberteil aus Metall gefertigt sein.

Zur Realisierung eines Sitzverstellschalters muss an dem mindestens einen Mehrwegekraftsensor eine Knopfkappe, also ein Betätigungselement, welches durch den Benutzer bedient wird, befestigt werden.

Nachteilig, speziell bei einem Mehrwegekraftsensor aus Metall, ist die kostenaufwendige Nachbearbeitung, die erforderlich ist, um eine geeignete Form zur Anbindung einer Knopfkappe, wie beispielsweise Klipse, Führflächen oder Hinterschnitte zu realisieren. In der Regel kommen hier Geometrien zum Einsatz welche durch einfache Drehprozesse oder rollierend hergestellt werden. Seltener kommen auch Fräsprozesse zum Einsatz. Die Metallzapfen der Mehrwegekraftsensoren werden so etwa mit Rändelungen, Zackenprofilen oder Passfedern versehen.

Die Schaffung eines Formschlusses ist hierbei in der Regel nur bedingt möglich, so dass die Befestigung einer Knopfkappe in der Regel reibschlüssig erfolgt. Es zeigte sich, dass die auf diese Weise erzeugten Verbindungen den Anforderungen bezüglich Abzugs- und Torsionskräften über alle Toleranzlagen und Temperaturbereiche oftmals nicht gerecht werden.

Es stellte sich die Aufgabe, einen gattungsgemäßen Sitzverstellschalter zu schaffen, der auf besonders einfache und kostengünstige Weise eine besonders stabile Anbindung einer Knopfkappe an Sensorzapfen ermöglicht.

Diese Aufgabe wird erfindungsgemäß dadurch gelöst, dass die Sensorzapfen durch Aufnahmehülsen hindurchgeführt sind, die einstückig mit der Trägerplatte ausgeführt und über flexible Bereiche mit anderen Abschnitten der Trägerplatte verbunden sind und dass die mindestens eine mit den Sensorzapfen verbundene Knopfkappe formschlüssige Verbindungen zu den Aufnahmehülsen ausbildet.

Nachfolgend soll ein Ausführungsbeispiel der Erfindung anhand der Zeichnung dargestellt und erläutert werden. Es zeigen
- Figur 1: einen Schnitt durch einen Sitzverstellschalter,
- Figur 2: eine Trägerplatte in einer Einzelteildarstellung, und
- Figur 3: ein Sensorelement in einer Einzelteildarstellung.

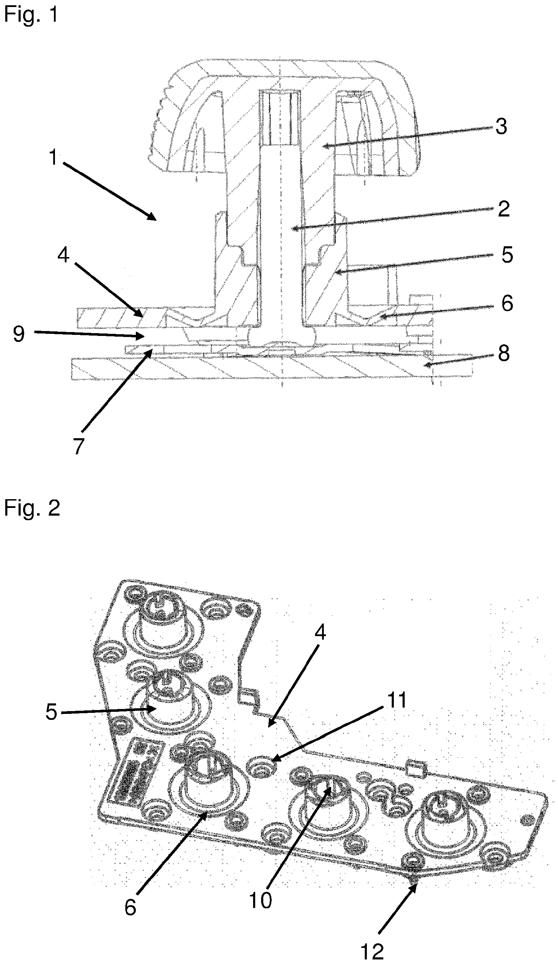

Ein montierter Sitzverstellschalter ist in der Figur 1 in einem Querschnitt entlang eines Mehrwegekraftsensors 1 mit einer angefügten Knopfkappe 3 dargestellt.

Der Mehrwegekraftsensor 1 funktioniert nach einem kapazitiven Messprinzip und besteht aus einem an einer Trägerplatte 4 angeordneten metallenen Sensorelement 9 und aus einer Leiterplatte 8, auf der, hier nicht dargestellte, Leiterstrukturen aufgebracht sind.

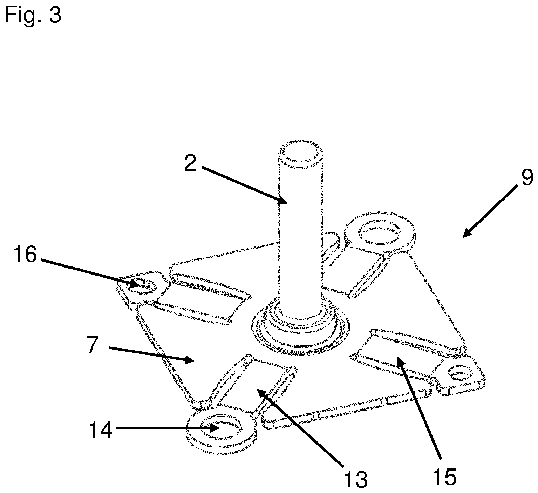

Das Sensorelement 9, welches in der Figur 3 als Einzelteil dargestellt ist, weist einen im Wesentlichen zylinderförmigen Sensorzapfen 2 auf. Mit dem unteren Endabschnitt des Sensorzapfens 2 ist eine metallene oder metallisierte Sensorplatte 7 verbunden, die bei einem Verschwenken des Sensorzapfens 2 um dessen Längsachse mit verschwenkt.

Hierdurch ändert sich die relative Lage der Sensorplatte 7 zu den auf der Leiterplatte 8 angeordneten Leiterstrukturen. Die Sensorplatte 7 bildet mit einzelnen dieser Leiterstrukturen Kondensatoren aus, deren Kapazitätswerte sich mit dem Verschwenken der Sensorplatte 7 verändern. Diese Kapazitätsänderungen können durch eine, hier ebenfalls nicht dargestellte, Elektronik ausgewertet werden, um die Lageänderung der Sensorplatte 7 und damit die auf den Sensorzapfen 2 wirkende Betätigungskraft zu ermitteln. Die Verschwenkung des Sensorzapfens 2 erfolgt mittels einer angefügten Knopfkappe 3.

Der Sitzverstellschalter weist hier beispielhaft insgesamt fünf solcher Mehrwegekraftsensoren 1 auf, die entweder mit mehreren einzelnen oder auch mit einer gemeinsamen Knopfkappe 3 verbunden sein können.

Zur Anordnung und Befestigung der Sensorelemente 9, sowie um eine stabile Kopplung zwischen der mindestens einen Knopfkappe 3 und den metallenen Sensorzapfen 2 der Sensorelemente 9 zu erreichen, ist eine Trägerplatte 4 vorgesehen.

Die Trägerplatte 4 als Einzelteil ist in der Figur 2 dargestellt. Die hier als separates Bauteil abgebildete Trägerplatte 4 kann alternativ auch angeformt in ein bestehendes Gehäuse integriert sein.

Die in der Figur 2 dargestellte Trägerplatte 4 ist als eine aus einem Kunststoff spritzgegossene ebene Platte ausgeführt, an die mehrere, hier entsprechend der vorgesehenen Anzahl von Sensoren fünf, Aufnahmehülsen 5 einstückig angeformt sind. Die Längsachsen der Aufnahmehülsen 5 sind senkrecht zur Plattenebene ausgerichtet. Um die Aufnahmehülsen 5 herum sind jeweils mehrere Anschrauböffnungen 11 erkennbar. Um die Aufnahmehülsen 5 herum sind zudem Zentrierstifte 12 angeordnet, die senkrecht von der Unterseite der Trägerplatte 4 abstehen.

Ein einzelnes Sensorelement 9 ist in der Figur 3 dargestellt. Das Sensorelement 9 besteht aus einer ursprünglich quadratischen oder rechteckförmigen Metallplatte, aus der in Richtung ihrer Diagonalen streifenförmige Anschraublaschen 13 und Zentrierarme 15 freigeschnitten sind. Die Endabschnitte dieser Anschraublaschen 13 und Zentrierarme 15 bilden Anschraubaugen 14 und Zentrieraugen 16 aus. Die Zentrieraugen 16 sind zwecks Zentrierung des Sensorelements 9 zur Trägerplatte 4 als Kombination aus Langloch und Loch ausgeführt.

Der mit den Anschraublaschen 13 und Zentrierarmen 15 einstückig verbundene Teil der Metallplatte bildet so eine etwa kleeblattförmige Sensorplatte 7 aus, mit deren Zentrum ein senkrecht abstehender, zylinderförmiger Sensorzapfen 2 fest verbunden ist.

Nach erfolgter Montage des Sitzverstellschalters sind mehrere Sensorelemente 9 an der Unterseite der in der Figur 2 dargestellten Trägerplatte 4 angeordnet, wobei deren Sensorzapfen 2 in die Aufnahmehülsen 5 eingesetzt sind und die Anschraublaschen 13 mit den Anschraubaugen 14 durch Schrauben mit den Anschrauböffnungen 11 der Trägerplatte 4 verbunden sind. Zur genauen Positionierung sind zudem die an der Unterseite der Trägerplatte 4 angeordneten Zentrierstifte 12 in die Zentrieraugen 16 des Sensorelements 9 eingesetzt.

Wie aus der Figur 1 hervorgeht, sind die Sensorzapfen 2 der Mehrwegekraftsensoren 1 dabei jeweils durch eine Aufnahmehülse 5 hindurchgeführt, so dass die Aufnahmehülsen 5 jeweils einen Teil der Länge eines Sensorzapfens 2 konzentrisch umgeben.

Um die Verschwenkbarkeit der Sensorzapfen 2 zu ermöglichen, bildet die Trägerplatte 4 um die Aufnahmehülsen 5 herum jeweils einen umlaufenden flexiblen Bereich 6 aus, der die Form eines Mäanders oder Faltenbalgs mit gleichzeitig stark reduzierter Wandstärke aufweist. Zusätzlich bietet diese Ausgestaltung den Vorteil, dass die Mehrwegekraftsensoren 1 vor Feuchtigkeit und Staub geschützt sind, da die umlaufenden flexiblen Bereiche 6 zwischen den Aufnahmehülsen 5 und den weiteren Bereichen der Trägerplatte 4 jeweils eine geschlossene Fläche ausbilden.

Vorteilhaft bei der Herstellung der Trägerplatte 4 ist, dass auf Grund der großflächigen Anbindung dieser ausgedünnten flexiblen Bereiche 6 immer noch genug Querschnitt zur Verfügung steht, um während des Spritzprozesses den inneren Bereich der Aufnahmehülsen 5 zu befüllen, ohne separate Einspritzpunkte vorhalten zu müssen.

In der Figur 1 ist weiterhin zu erkennen, dass der freie Endabschnitt des Sensorzapfens 2 in die Knopfkappe 3 eingesetzt und von in die Knopfkappe 3 eingeformten Innenwänden umgeben ist. Die Außenwände der Knopfkappe 3 sind in den oberen, erweiterten Teil der Aufnahmehülse 5 eingesetzt.

Die Aufnahmehülsen 5 sind dazu so gestaltet, dass sie formschlüssige Verbindungen zu der mindestens einen Knopfkappe 3 herstellen und die auf die Knopfkappe 3 eingeleiteten Zugkräfte und Drehmomente aufnehmen können. Zur Schaffung eines Formschlusses können die Aufnahmehülsen 5 beispielsweise eingeformte Nuten 10 aufweisen, wie sie in der Figur 2 erkennbar sind. In diese Nuten 10 können an der Knopfkappe 3 angeformte Stege eingesetzt werden.

Da so einerseits zwischen der mindestens einen Knopfkappe 3 und den Aufnahmehülsen 5 formschlüssige Verbindung bestehen und die Sensorzapfen 2 jeweils sowohl von einer Aufnahmehülse 5 als auch der mindestens einen Knopfkappe 3 umgeben sind, sind zusätzliche reib- oder formschlüssige Verbindungen zwischen den Sensorzapfen 2 und der mindestens einen Knopfkappe 3 nicht erforderlich.

Daher können die Sensorzapfen 2, wie besonders deutlich die Figur 3 zeigt, jeweils als ein einfacher zylindrischer Metallstift ausgebildet sein. Aufwendige Nacharbeiten zur Anformung von Verbindungsstrukturen an Endabschnitten der Sensorzapfens 2 können so vorteilhafterweise eingespart werden.

### Bezugszeichen

- 1: Mehrwegekraftsensor
- 2: Sensorzapfen
- 3: Knopfkappe
- 4: Trägerplatte
- 5: Aufnahmehülse
- 6: flexible Bereiche
- 7: Sensorplatte
- 8: Leiterplatte
- 9: Sensorelement
- 10: Nuten
- 11: Anschrauböffnungen
- 12: Zentrierstifte
- 13: Anschraublaschen
- 14: Anschraubaugen
- 15: Zentrierarme
- 16: Zentrieraugen

## Patentansprüche

1. Sitzverstellschalter mit mehreren über Sensorzapfen (2) betätigbaren Mehrwegekraftsensoren (1), die an einer gemeinsamen Trägerplatte (4) angeordnet sind,
wobei mit den Sensorzapfen (2) mindestens eine Knopfkappe (3) als Betätigungselement verbunden ist,
**dadurch gekennzeichnet,**
**dass** die Sensorzapfen (2) durch Aufnahmehülsen (5) hindurchgeführt sind, die einstückig mit der Trägerplatte (4) ausgeführt und über flexible Bereiche (6) mit anderen Abschnitten der Trägerplatte (4) verbunden sind und
**dass** die mindestens eine mit den Sensorzapfen (2) verbundene Knopfkappe (3) formschlüssige Verbindungen zu den Aufnahmehülsen (5) ausbildet.

2. Sitzverstellschalter nach Anspruch 1, **dadurch gekennzeichnet, dass** die flexiblen Bereiche (6) durch geschwächte ringförmige Bereiche der Trägerplatte (4) rund um die Aufnahmehülsen (5) herum ausgebildet sind.

3. Sitzverstellschalter nach Anspruch 1 oder 2, **dadurch gekennzeichnet, dass** die flexiblen Bereiche (6) faltenbalgartig ausgeführt.

4. Sitzverstellschalter nach Anspruch 1, **dadurch gekennzeichnet, dass** die Mehrwegekraftsensoren (1) jeweils eine Sensorplatte (7) und einen senkrecht von der Sensorplatte (7) abstehenden Sensorzapfen (2) aufweisen, die beide aus Metall bestehen.

## Claims

1. Seat adjustment switch having a plurality of multi-way force sensors (1) which can be actuated via sensor pins (2) and are arranged on a common carrier plate (4),
at least one button cap (3) being connected to the sensor pins (2) as an actuating element,
**characterized in that** the sensor pins (2) are guided through receiving sleeves (5) which are designed in one piece with the carrier plate (4) and are connected to other sections of the carrier plate (4) via flexible regions (6), and
**in that** the at least one button cap (3) connected to the sensor pins (2) forms form-fitting connections to the receiving sleeves (5).

2. Seat adjustment switch according to claim 1, **characterized in that** the flexible areas (6) are formed by weakened annular areas of the carrier plate (4) around the receiving sleeves (5).

3. Seat adjustment switch according to claim 1 or 2, **characterized in that** the flexible areas (6) are designed in the manner of bellows.

4. Seat adjustment switch according to claim 1, **characterized in that** the multipath force sensors (1) each have a sensor plate (7) and a sensor pin (2) projecting perpendicularly from the sensor plate (7), both of which are made of metal.

## Revendications

1. Commutateur de réglage de siège comportant plusieurs capteurs de force à plusieurs voies (1) pouvant être actionnés par l'intermédiaire de tourillons de capteur (2), qui sont disposés sur une plaque de support commune (4),
au moins un capuchon de bouton (3) étant relié aux tourillons de capteur (2) en tant qu'élément d'actionnement,
**caractérisé en ce que** les tenons de capteur (2) sont guidés à travers des douilles de réception (5) qui sont réalisées d'une seule pièce avec la plaque de support (4) et sont reliées par des zones flexibles (6) à d'autres sections de la plaque de support (4) et
**en ce que** l'au moins un capuchon de bouton (3) relié aux tourillons de capteur (2) forme des liaisons par complémentarité de forme avec les douilles de réception (5).

2. Commutateur de réglage de siège selon la revendication 1, **caractérisé en ce que** les zones flexibles (6) sont formées par des zones annulaires affaiblies de la plaque de support (4) autour des douilles de réception (5).

3. Commutateur de réglage de siège selon la revendication 1 ou 2, **caractérisé en ce que** les zones flexibles (6) sont réalisées sous forme de soufflet.

4. Commutateur de réglage de siège selon la revendication 1, **caractérisé en ce que** les capteurs de force à plusieurs voies (1) présentent chacun une plaque de capteur (7) et un tourillon de capteur (2) dépassant perpendiculairement de la plaque de capteur (7), les deux étant en métal.
